# EUROPÄISCHE PATENTSCHRIFT

(11) **EP 2 590 003 B1**
(45) Veröffentlichungstag und Bekanntmachung des Hinweises auf die Patenterteilung: **26.04.2017**
(21) Anmeldenummer: 12189651.8
(22) Anmeldetag: 24.10.2012
(51) Int. Cl.: G02B 6/14, H01S 5/00, B23K 26/00, G02B 27/09, B23K 26/06

(54) **Vorrichtung zum Einstellen eines Strahlprofils, Laserbearbeitungsmaschine und Verfahren zur Herstellung der Vorrichtung**
Apparatus for adjusting a beam profile, laser processing machine, and method of manufacturing the apparatus
Dispositif de reglage d'un profil de faisceau, machine de traitement au laser et procédé de fabrication dudit dispositif

(30) Priorität: 07.11.2011 DE 102011085840
(43) Veröffentlichungstag der Anmeldung: 08.05.2013
(73) Patentinhaber: TRUMPF Laser GmbH, 78713 Schramberg (DE)
(72) Erfinder: Olschowsky, Peter, 78713 Schramberg (DE); Huber, Rudolf, 78554 Aldingen-Aixheim (DE); Fuchs, Stefan, 78661 Böhringen (DE)
(74) Vertreter: Kohler Schmid Möbus Patentanwälte

(56) Entgegenhaltungen:
- DE-A1- 3 509 421
- JP-A- 60 068 302
- US-A1- 2006 072 877
- US-A1- 2007 147 758
- US-A1- 2009 208 170
- US-A1- 2010 150 201

## Beschreibung

Die vorliegende Erfindung betrifft eine Vorrichtung zum Einstellen eines Strahlprofils, eine Laserbearbeitungsmaschine mit einer solchen Vorrichtung, sowie ein Verfahren zur Herstellung einer solchen Vorrichtung.

Wird von einer Strahlquelle Licht an einem Ende in einen Lichtleiter eingekoppelt, wird das Strahlprofil am anderen Ende des Lichtleiters nicht nur von der Strahlquelle, sondern auch von den Homogenisierungseigenschaften des Lichtleiters bestimmt. Die für eine Laserbearbeitungsmaschine gewünschte Nahfeld-Leistungsverteilung am austrittsseitigen Ende des Lichtleiters kann (in radialer Richtung) beispielsweise als spitzer Berg (Kegelspitze mit ausgeprägtem Intensitätsmaximum am Strahlzentrum) oder als flacher Berg (Zylinderform, d.h. Plateau mit im Wesentlichen konstanter Intensität, "top-hat") ausgeprägt sein. Durch Einstellung eines Strahlprofils mit einem ausgeprägten Intensitätsmaximum im Strahlzentrum kann die Einschweißtiefe bei einem Laserschweißprozess vergrößert werden. Durch Einstellung eines top-hat Profils kann hingegen eine breite Naht und somit eine größere Anbindebreite zwischen zwei zu verschweißenden Werkstücken erreicht werden.

Die US 2010/0150201 A1 beschreibt die Einkopplung von Laserstrahlung eines Faserbündels in eine einzelne Faser eines Lichtleitkabels. Zur besseren Ausrichtung der Faser relativ zur in diese eintretenden Strahlung wird ein Modenmischer verwendet, der eine Einrichtung zur Veränderung der Krümmung des Lichtleitkabels aufweist. Eine Homogenisierung der Energiedichte des Laserstrahls soll erreicht werden, indem das Lichtleitkabel in Schleifen gewickelt wird.

Aus der KR 10-2010-0068694 (Kim Jom Sool) ist eine Vorrichtung bekannt geworden, bei der ein Abschnitt eines Lichtleitkabels verbogen wird, um eine gleichmäßige Helligkeitsverteilung eines in dem Lichtleitkabel geführten Laserstrahls zu erreichen. Zu diesem Zweck wird das Lichtleitkabel an zwei Stellen an einer Befestigungsplatte fixiert und eine dazwischen angeordnete Bewegungseinrichtung verschiebt den zwischen den beiden Stellen verlaufenden Abschnitt des Lichtleitkabels, um dessen Krümmung einzustellen.

Um Lichtleiter vor Beschädigung durch äußere Einflüsse zu schützen sind diese i.A. mit einem Schutzschlauch umgeben und bilden ein Lichtleitkabel. Der Schutzschlauch dient dazu, Zug-, Biege- und Querdruckbeanspruchungen des Lichtleitkabels standzuhalten. Insbesondere wenn der Lichtleiter zum Transport eines Laserstrahls mit hoher Leistung verwendet wird, sollte der Schutzschlauch auch gewährleisten, dass auf den Lichtleiter keine Kräfte einwirken können, die zu einer Verspannung oder Verformung des Lichtleiters führen. Ein solcher Schutzschlauch ist beispielsweise aus der DE 20 2004 004 817 U1 bekannt geworden. Der dort beschriebene Schutzschlauch weist eine hohe Steifigkeit auf, so dass dieser nur bis zu einem minimalen Biegeradius von 150 mm gebogen werden kann, bei dem bei den dort verwendeten Lichtleiter-Durchmessern noch keine schädlichen Kräfte auf den Lichtleiter einwirken.

### Aufgabe der Erfindung

Es ist eine Aufgabe der vorliegenden Erfindung, eine Vorrichtung zum Einstellen eines Strahlprofils anzugeben, die einerseits eine flexible Strahlformung ermöglicht und andererseits den Lichtleiter ausreichend vor Beschädigungen aufgrund äußerer Einwirkungen schützt.

### Gegenstand der Erfindung

Diese Aufgabe wird erfindungsgemäß gelöst durch eine Vorrichtung zum Einstellen eines Strahlprofils eines Laserstrahls, der in einem mit einer Schutzummantelung versehenen Lichtleiter eines Lichtleitkabels (auch als LaserLichtKabel, LLK, bezeichnet) geführt ist, wobei die Vorrichtung umfasst: eine Verformungseinrichtung zur Verformung des Lichtleiters in einem nicht von der Schutzummantelung umgebenen Abschnitt des Lichtleitkabels, ein Gehäuse, welches ausgebildet ist, den Lichtleiter zumindest in dem nicht von der Schutzummantelung umgebenen Abschnitt zu umgeben, sowie zwei an gegenüberliegenden Enden des Gehäuses vorgesehene Aufnahmen zur Befestigung jeweils eines Endes eines Abschnitts der Schutzummantelung, wobei die Aufnahmen jeweils eine Öffnung zur Zuführung des Lichtleiters zu der Verformungseinrichtung aufweisen.

Die Einstellung des Strahlprofils erfolgt bei der erfindungsgemäßen Vorrichtung durch Krafteinwirkung, z.B. durch Verbiegung, eines nicht von der Schutzummantelung umgebenen Abschnitts des Lichtleiters, wodurch kleinere Biegeradien realisiert werden können als in den Abschnitten, in denen der Lichtleiter von einem Schutzschlauch umgeben ist. Gleichzeitig wird durch die Anordnung des nicht von der Schutzummantelung umgebenen Abschnitts innerhalb des Gehäuses sichergestellt, dass der Lichtleiter auch in diesem Bereich gegen äußere Einwirkungen geschützt ist. Die außerhalb der Verformungseinrichtung vorgesehene Schutzummantelung verhindert, dass außerhalb des Gehäuses Kräfte auf den Lichtleiter wirken können, welche den Transport der Hochleistungs-Laserstrahlung stören. Mit der erfindungsgemäßen Vorrichtung kann die Schutzummantelung des Lichtleitkabels in den Aufnahmen fixiert werden, während der nicht von der Schutzummantelung umgebene Abschnitt des Lichtleiters der Verformungseinrichtung zugeführt und dort verformt wird.

Vorzugsweise weist die Verformungseinrichtung einen Durchlass zum Durchtritt des Lichtleiters auf, der quer zu den Aufnahmen bewegbar ist. Die Aufnahmen zur Befestigung der Schutzummantelung sind in Längsrichtung des zugeführten Lichtleiters voneinander beabstandet und die Verformungseinrichtung ist zwischen den beiden Aufnahmen angeordnet, die aus mehreren Bauteilen bestehen können, welche in ihrer relativen Lage zueinander fixiert sind. Die Aufnahmen sind vorzugsweise entlang einer gemeinsamen Achse ausgerichtet Die Bewegung des Durchlasses erfolgt in diesem Fall typischer Weise in einer Ebene senkrecht zu dieser gemeinsamen Achse. Durch die Bewegung des Durchlasses relativ zu den Aufnahmen kann eine Verbiegung des durch den Durchlass der Verformungseinrichtung geführten Lichtleiters realisiert werden, da die Aufnahmen über das Gehäuse starr miteinander verbunden sind. Die Verformungseinrichtung kann ausgebildet sein, eine lineare Verschiebung des Durchlasses relativ zu den Aufnahmen zu bewirken und auf diese Weise den Lichtleiter zu verbiegen. Alternativ zu einer Verbiegung des Lichtleiters kann die Verformungseinrichtung auch ausgebildet sein, das Strahlprofil durch eine Torsion des Lichtleiters oder durch Ausübung von Druck auf die Mantelfläche des Lichtleiters zu verändern.

Eine besonders bevorzugte Ausführungsform sieht vor, dass die Verformungseinrichtung relativ zu den Aufnahmen um eine Drehachse verdrehbar ist, die zu einer von den Öffnungen in den Aufnahmen gebildeten Zuführungsachse versetzt, d.h. von dieser beabstandet ist. Die Öffnungen, die insbesondere als Zuführungskanäle ausgebildet sein können, legen die Zuführungsachse fest. Die Drehachse und die Zuführungsachse verlaufen typischer Weise parallel zueinander. Der Grad der Verformung bzw. der Verbiegung des Lichtleiters kann in diesem Fall über den Drehwinkel der Verformungseinrichtung eingestellt werden, wobei die Einstellung typischer Weise stufenlos erfolgt und bei genau einem Drehwinkel (Ausgangsstellung) der Lichtleiter ohne eine Verbiegung durch die Verformungseinrichtung geführt ist. Eine gute Leistungshomogenisierung (top-hat Profil) kann beispielsweise durch eine U-förmige bzw. S-förmige Verbiegung des Lichtleiters erreicht werden. Unter einer U-förmigen Verbiegung wird eine Verbiegung verstanden, bei welcher der Lichtleiter z.B. von links kommt, nach Unten durchgebogen wird, U-formig wieder zurück verläuft und dann nach rechts weiter läuft.

Bei einer Weiterbildung ist die Verformungseinrichtung als Hohlzylinder ausgebildet, der als Durchlass eine exzentrische Bohrung aufweist. Der Durchlass bzw. die Bohrung verläuft exzentrisch zur Mittelachse des Hohlzylinders, welche die Drehachse bildet, so dass mit dem Hohlzylinder eine einfache Form eines Exzenters realisiert werden kann. Der Hohlzylinder kann insbesondere zwei sich zu dem Durchlass hin verjüngende Bohrungsabschnitte aufweisen, um eine Durchführung des Lichtleiters durch den Durchlass zu erleichtern.

Um eine einfache und bequeme Bedienung zu ermöglichen, ist es vorteilhaft, wenn die Verformungseinrichtung ein Bedienelement aufweist, welches durch eine Öffnung in dem Gehäuse verläuft und von außerhalb des Gehäuses betätigbar ist. Das Bedienelement ist vorzugsweise starr mit der Verformungseinrichtung verbunden, so dass eine Bewegung des Bedienelements unmittelbar in eine Bewegung der Verformungseinrichtung umgesetzt wird. Als Bedienelement kommt bspw. ein Stift in Frage, der durch eine Öffnung z.B. in Form eines sich über einen bestimmten Winkelbereich erstreckenden Spalts im Gehäuse geführt ist und entlang dieser Öffnung relativ zum Gehäuse verdreht werden kann, wobei die Verdrehbewegung beispielsweise über einen Winkelbereich von maximal 180° erfolgen kann. Um die Öffnung bzw. den Spalt gegenüber der Umgebung abzudichten sowie um eine zusätzliche Führung des Bedienelements zu ermöglichen, kann eine z.B. manschettenartige Abdeckung an der Außenseite des Gehäuses vorgesehen und starr mit dem Bedienelement verbunden sein. Es versteht sich, dass an der Außenseite des Gehäuses und/oder an der Abdeckung auch eine Skala, z.B. eine Winkelskala, vorgesehen werden kann, um den Grad der Verformung bzw. Verbiegung des Lichtleiters anzuzeigen.

Bei einer bevorzugten Ausführungsform ist die Verformungseinrichtung ausgebildet, den Lichtleiter in dem nicht ummantelten Abschnitt des Lichtleitkabels bis zu einem minimalen Biegeradius von 40 mm, bevorzugt von 25 mm, besonders bevorzugt von 10 mm zu verbiegen, um auf diese Weise eine signifikante Veränderung des Strahlprofils zu ermöglichen. Die hier angegebenen Krümmungsradien können typischer Weise nicht durch Verbiegen eines Lichtleitkabels erfolgen, bei welchem der Lichtleiter von der Schutzummantelung umgeben ist, da diese eine zu starke Verbiegung des Lichtleiters gerade verhindern soll. Der für eine ideale Strahlprofileinstellung erforderliche (minimale) Biegeradius hängt auch vom Durchmesser des Lichtleiters (z.B. Quarzfaser) ab. Die hier angegebenen Werte sind typisch für einen Durchmesser von mehr als ca. 600 µm. Bei kleineren Durchmessern (z.B. von mehr als ca. 100 µm) werden in der Regel entsprechend geringere (minimale) Biegeradien verwendet.

Eine bevorzugte Ausführungsform der Vorrichtung umfasst ein Lichtleitkabel, dessen Lichtleiter durch die Aufnahmen und die dazwischen angeordnete Verformungseinrichtung geführt ist, wobei die Schutzummantelung zwei Abschnitte umfasst, die jeweils einen Abschnitt des Lichtleiters außerhalb der Verformungseinrichtung umgeben, wobei das der Verformungseinrichtung zugewandte Ende jedes Abschnitts in jeweils einer der Aufnahmen fixiert ist. Die Abschnitte (Teilschläuche) der Schutzummantelung schützen den Lichtleiter im Bereich außerhalb der Verformungseinrichtung vor Beschädigungen und sind in den Aufnahmen fixiert, z.B. dort eingesteckt, so dass ein Abrutschen der Schutzummantelung vom Lichtleiter verhindert wird. Innerhalb der Verformungseinrichtung kann indessen die gewünschte Strahlprofileinstellung unabhängig von den Eigenschaften der Schutzummantelung vorgenommen werden. Gegebenenfalls kann im Bereich der Aufnahmen eine Dichtung z.B. in Form eines O-Ringes angebracht sein, welche die Mantelfläche der in den Aufnahmen fixierten Schutzummantelung umgibt. Es versteht sich, dass ein jeweiliger Abschnitt der Schutzummantelung auch mehrere in ineinander geschachtelte Teilschläuche aufweisen kann, z.B. einen radial innen liegenden Teilschlauch, der von einem radial außen liegenden Teilschlauch umgeben ist.

Lichtleitkabel, die zum Transport von Laserstrahlung von einer Laserquelle zu einem Laserbearbeitungskopf in einer Laserbearbeitungsmaschine verwendet werden, sind in der Regel mit einer Schutzummantelung ausgestattet, die eine Verbiegung des Lichtleiters mit einem Biegeradius kleiner als 200 mm bzw. kleiner als 150 mm verhindert. Eine Strahlprofileinstellung in der gewünschten Qualität ist mit solchen Biegeradien in der Regel nicht möglich, so dass eine Verbiegung des Lichtleiters relativ zur Schutzummantelung auf die oben beschriebene Weise erforderlich ist.

Die Erfindung betrifft auch eine Laserbearbeitungsmaschine mit einer Vorrichtung wie oben beschrieben, bei der das Lichtleitkabel typischer Weise für den Transport von Laserstrahlung von einer Laserquelle zu einem Laserbearbeitungskopf verwendet wird.

Ein weiterer Aspekt der Erfindung betrifft ein Verfahren zur Herstellung der oben beschriebenen Vorrichtung, umfassend die Schritte: Durchführen des Lichtleiters des Lichtleitkabels durch den Durchlass der Verformungseinrichtung, Versehen des Lichtleiters mit jeweils einem Abschnitt der Schutzummantelung an gegenüberliegenden Enden des Gehäuses, sowie Fixieren eines Endes jedes Abschnitts in jeweils einer der Aufnahmen. Auf diese Weise kann eine Vorrichtung bereitgestellt werden, bei welcher der Lichtleiter zumindest im Bereich der Veformungseinrichtung nicht von einer Schutzummantelung umgeben ist.

Weitere Vorteile der Erfindung ergeben sich aus der Beschreibung und der Zeichnung. Ebenso können die vorstehend genannten und die noch weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: eine Schnittdarstellung einer Vorrichtung zur Strahlprofileinstellung mit einer Verformungseinrichtung in einer ersten Winkelstellung, in der ein Lichtleiter ohne Verbiegung durch einen Durchlass der Verformungseinrichtung hindurchgeführt wird;
- Fig. 2: eine Schnittdarstellung der Vorrichtung zur Strahlprofileinstellung mit einer Verformungseinrichtung in einer zweiten Winkelstellung, in welcher der Lichtleiter im Bereich des Durchlasses eine Krümmung aufweist;
- Fig. 3: eine Außenansicht auf die Vorrichtung von Fig. 1 und Fig. 2; und
- Fig. 4: eine Laserbearbeitungsmaschine mit einer Vorrichtung zur Strahlprofileinstellung gemäß Fig. 1 bis Fig. 3.

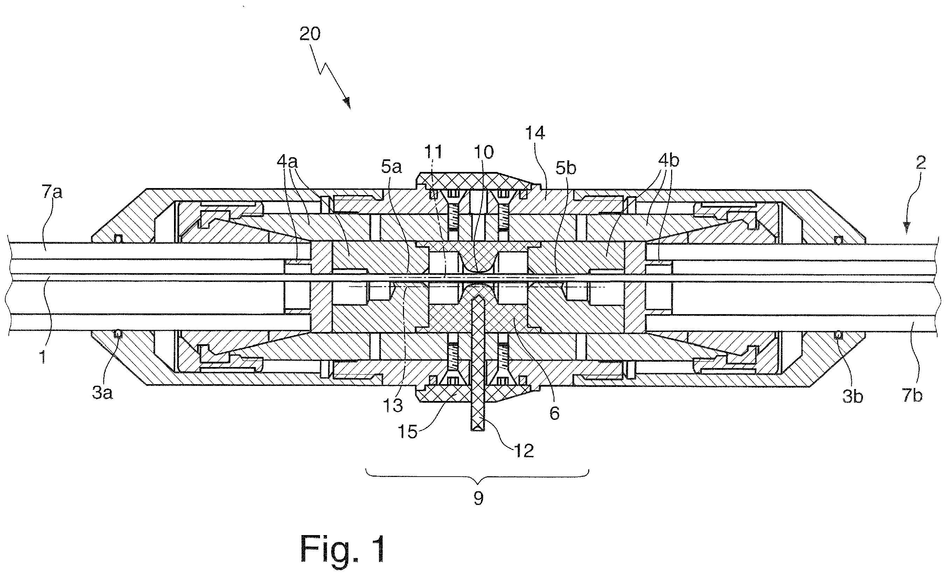

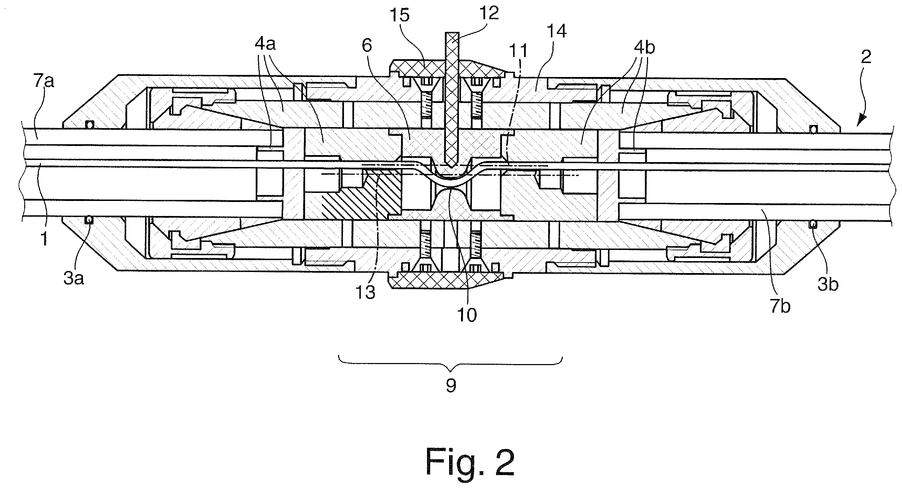

Fign. 1, 2 zeigen eine Vorrichtung 20 zur Strahlprofileinstellung eines (nicht gezeigten) Laserstrahls, welcher in einem Lichtleiter **1** eines Lichtleitkabels **2** geführt ist, in zwei unterschiedlichen Winkelstellungen einer Verformungseinrichtung **6,** die im vorliegenden Beispiel zur Verbiegung des Lichtleiters 1 ausgebildet ist und die einen Durchlass **10** für den Lichtleiter 1 aufweist.

Ein Gehäuse **14** umgibt den Bereich der Verformungseinrichtung 6 sowie zwei Aufnahmen **4a, 4b,** durch die der Lichtleiter 1 der Verformungseinrichtung 6 zugeführt werden kann, indem der Lichtleiter 1 bei der in Fig. 1 gezeigten Winkelstellung der Verformungseinrichtung 6 in die erste Aufnahme 4a eingeführt wird. Der Lichtleiter 1 wird hierbei über eine erste Öffnung **5a** der ersten Aufnahme 4a dem Durchlass 10 der Verformungseinrichtung 6 zugeführt. Der Lichtleiter 1 tritt über eine zweite Öffnung **5b** an der zweiten Aufnahme 4b hindurch und wird an der zweiten Aufnahme 4b aus dem Gehäuse 14 herausgeführt. Die Öffnungen 5a, 5b der Aufnahmen 4a, 4b und der Durchlass 10 sind hierbei in der in Fig. 1 gezeigten Winkelstellung der Verformungseinrichtung 6 entlang einer gemeinsamen Zuführungsachse **11** angeordnet, so dass der Lichtleiter 1 problemlos durch die Öffnungen 5a, 5b und den Durchlass 10 der Verformungseinrichtung 6 hindurchgeführt werden kann. Die Verformungseinrichtung 6 ist im vorliegenden Beispiel als Kreis-Zylinder mit einer exzentrischen Bohrung in Form eines Doppeltrichters ausgeführt, dessen minimaler Durchmesser den Durchlass 10 bildet.

Das Lichtleitkabel 2 umfasst im vorliegenden Beispiel eine Schutzummantelung **7a, 7b,** die den Lichtleiter 1 ringförmig umgibt und vor äußeren Einflüssen, insbesondere Beschädigung und übermäßiger Verbiegung schützt. Die Schutzummantelung umfasst zwei Abschnitte 7a, 7b, die nach Einführen des Lichtleiters 1 in die Verformungseinrichtung 6 über die Enden des Lichtleiters 1 geschoben werden. Die dem Gehäuse 14 zugewandten Enden der Abschnitte 7a, 7b werden in den Aufnahmen 4a, 4b befestigt, im vorliegenden Beispiel festgeklemmt. Zur Abdichtung gegen die Umgebung sind an einer jeweiligen Aufnahme 4a, 4b Dichtungen **3a, 3b** in Form von O-Ringen vorgesehen. Da die Abschnitte bzw. Teilschläuche 7a, 7b an bzw. zumindest abschnittsweise in den Aufnahmen 4a, 4b enden, weist das Lichtleitkabel 2 zwischen den Aufnahmen 4a, 4b einen Abschnitt **9** ohne Ummantelung auf, in dem die Verformungseinrichtung 6 vorgesehen ist. Durch das Gehäuse 14 werden sowohl der nicht ummantelte Abschnitt 9 des Lichtleiters 1 als auch die Übergänge vom nicht ummantelten Abschnitt 9 zu den Abschnitten 7a, 7b der Schutzummantelung vor äußeren Einflüssen geschützt.

Mittels eines Bedienelements **12,** welches im gezeigten Beispiel mit der Verformungseinrichtung 6 starr verbunden ist, kann die Verformungseinrichtung 6 um eine Drehachse **13** verdreht werden, weiche die Symmetrieachse der zylindrischen Verformungseinrichtung 6 sowie des Gehäuses 14 bildet. Die Verdrehung der Verformungseinrichtung 6 kann auch auf andere Weise, z.B. mittels einer Schraube oder eines Motors realisiert werden. Mittels des Bedienelements 12 kann die Verformungseinrichtung 6 in eine zweite Winkelstellung gedreht werden, welche in Fig. 2 gezeigt ist und bei der die Verformungseinrichtung 6 in einer um 180° zur in Fig. 1 gezeigten Winkelstellung verdreht wurde. Da der Durchlass 10 exzentrisch zur Drehachse 13 angeordnet ist, bewegt sich der Durchlass 10 beim Verdrehen der Verformungseinrichtung 6 entlang einer Kreisbahn senkrecht zur Drehachse 13. Der Durchlass 10 verläuft hierbei zwar noch parallel zur Zuführungsachse 11, ist aber von dieser beabstandet. Dies hat zur Folge, dass der Abschnitt 9 des Lichtleiters 1, der sich innerhalb der Verformungseinrichtung 6 befindet, verbogen wird, wie dies in Fig. 2 gezeigt ist. Der Lichtleiter 1 kann also durch Betätigen des Bedienelements 12 aus der gestreckten Lage in eine gebogene bzw. gekrümmte Lage gebracht werden, wobei die Krümmung des Lichtleiters 1 mit zunehmendem Abstand zwischen der Zuführungsachse 11 und dem Durchlass 10 zunimmt. Bei der in Fig. 2 gezeigten Winkelstellung ist dieser Abstand maximal. Die Abmessungen des Gehäuses 14 und insbesondere der Abstand zwischen der Zuführungsachse 11 und der Drehachse 13 sowie die Länge des Durchlasses 10 sind hierbei so gewählt, dass in dieser Winkelstellung ein (minimaler) Biegeradius von 40 mm, günstiger Weise von 25mm, insbesondere von 10 mm erreicht werden kann.

Durch die Verbiegung des Lichtleiters 1 wird auf dem bzgl. der Biegung innen gelegenen Teil des Lichtleiters 1, d.h. dem in Fig. 2 nach oben zeigenden Teil des U-förmig gekrümmten Abschnitts 9 des Lichtleiters 1 eine Druckspannung erzeugt, während auf dem gegenüber liegenden, bzgl. der Biegung äußeren Teil des U-förmigen Abschnitts eine Zugspannung erzeugt wird. Diese Spannungsunterschiede können z.B. eine Änderung des Brechungsindex innerhalb des Lichtleiters 1 bewirken, so dass die Änderung des Grades der Verbiegung (Änderung des Krümmungsradius) eine Änderung des Strahlprofils bewirkt. Auf diese Weise kann das Strahlprofil des im Lichtleiter 1 geführten Laserstrahls an eine gewünschte Anwendung angepasst werden. Je stärker die Biegung (also je kleiner der Biegeradius) desto stärker kann das Strahlprofil einem top-hat-Profil angenähert werden.

Mit der in Fig. 1 und Fig. 2 gezeigten Verformungseinrichtung 6 kann der Lichtleiter 1 in eine Form gebracht werden, deren Krümmung zweimal das Vorzeichen ändert. Es besteht aber auch die Möglichkeit, durch eine entsprechend ausgebildete Verformungseinrichtung mehr als zwei Krümmungsänderungen zu bewirken, um das Strahlprofil zu optimieren. Alternativ oder zusätzlich zur Verbiegung des Lichtleiters 1 kann die Verformungseinrichtung 6 auch ausgebildet sein, den Lichtleiter 1 zu tordieren oder Druck auf den (nicht gekrümmten) Lichtleiter 1 auszuüben. Auch hierdurch wird der Brechungsindex des Lichtleiters 1 im Bereich der Verformung verändert, was für eine Strahlprofileinstellung ausgenutzt werden kann.

Es versteht sich, dass die hier beschriebene Vorrichtung 20 auch mit Lichtleitkabeln verwendet werden kann, die lediglich eine einzige Schutzummantelung oder mehr als zwei ineinander geschachtelte Schutzummantelungen aufweisen. Die Aufnahmen müssen dann eine entsprechende Anzahl an Befestigungseinrichtungen für die jeweilige Schutzummantelung aufweisen. Die Schutzummantelung kann beispielsweise wie in der DE 20 2004 004 817 U1 beschrieben ausgeführt sein. Sie dient lediglich der Erzeugung von mechanischer Stabilität, hat jedoch keine strahlführende Wirkung. Der minimale Biegeradius des Lichtleiters 1, der mit der Schutzummantelung 7a; 7b erreicht werden kann, liegt bei ca. 150 mm und ist somit deutlich größer als die Biegeradien, die an dem nicht von der Schutzummantelung 7a; 7b umgebenen Abschnitt 9 des Lichtleiters 1 erzeugt werden können.

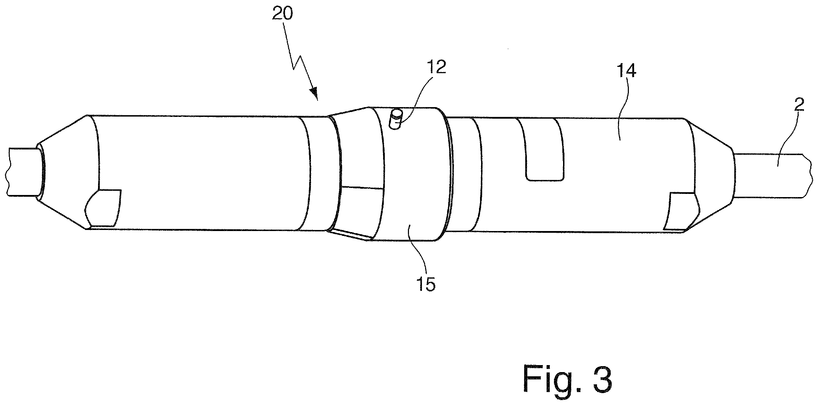

**Fig. 3** zeigt eine Außenansicht der Strahlformungsvorrichtung 20 von Fig. 1 und Fig. 2. Das Bedienelement 12 ist in Form eines Stiftes ausgebildet, der mit einer Manschette **15** verbunden ist, die an der Außenseite des Gehäuses 14 angebracht ist, so dass eine Drehung der Verformungseinrichtung 6 durch Krafteinwirkung auf den Stift 12 und/oder die Manschette 15 erreicht werden kann. Die Manschette 15 dient auch als Abdeckung für eine schlitzförmige Öffnung in dem Gehäuse 14 (vgl. Fig. 1 und Fig. 2), durch die der Stift 12 geführt ist und die sich im vorliegenden Beispiel über einen Winkelbereich von 180° erstreckt. Für eine reproduzierbare Strahlprofileinstellung kann die Manschette 15 oder das Gehäuse 14 mit einer (Winkel-)Skala versehen sein und als Stellrad fungieren.

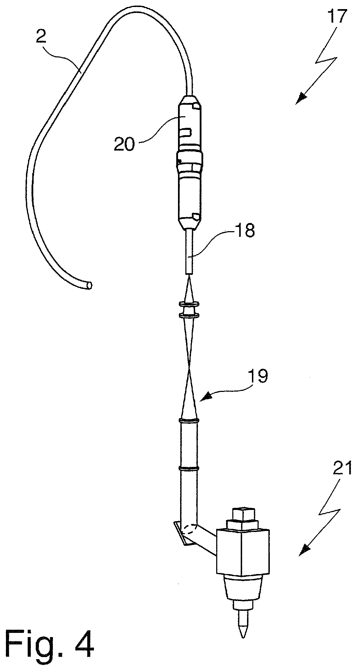

**Fig. 4** zeigt einen Ausschnitt einer Laserbearbeitungsmaschine **17** mit einer Vorrichtung 20 zu Strahlprofileinstellung entsprechend Fign. 1-3, bei der Laserstrahlung von einer (nicht gezeigten) Laserstrahlquelle mittels des Lichtleitkabels 2 einer Strahlführung **19** zur freien Propagation des Laserstrahls **18** zugeführt wird, welche den Laserstrahl 18, der in der Vorrichtung 20 mit dem gewünschten Strahlprofil versehen wurde, einem Laserbearbeitungskopf **21** zuführt. Mittels der Vorrichtung 20 kann die Form der Intensitätsverteilung des Laserstrahls 18 abhängig von der Art der durchzuführenden Laserbearbeitung eingestellt werden.

Insgesamt ermöglicht die oben beschriebene Vorrichtung 20 einen zuverlässigen Transport von Laserstrahlung mittels eines Lichtleitkabels 2 mit einem Strahlprofil, das im Wesentlichen unabhängig von der Strahlquelle einstellbar ist.

## Patentansprüche

1. Vorrichtung (20) zum Einstellen eines Strahlprofils eines Laserstrahls, umfassend:
ein Lichtleitkabel (2), welches eine Schutzummantelung (7a, 7b) und einen Lichtleiter (1) aufweist, in dem der Laserstrahl geführt ist,
eine Verformungseinrichtung (6) zur Verformung des Lichtleiters (1) in einem nicht von der Schutzummantelung umgebenen Abschnitt (9) des Lichtleitkabels (2), sowie zwei Aufnahmen (4a, 4b) zur Befestigung jeweils eines Endes eines Abschnitts (7a, 7b) der Schutzummantelung, wobei die Aufnahmen (4a, 4b) jeweils eine Öffnung (5a, 5b) zur Zuführung des Lichtleiters (1) zu der Verformungseinrichtung (6) aufweisen
**dadurch gekennzeichnet, dass**
das Lichtleitkabel zumindest einen nicht von der Schutzummantelung umgebenen Abschnitt umfasst, dadurch dass die Vorrichtung ein Gehäuse umfasst, welches ausgebildet ist, den Lichtleiter zumindest in dem nicht von der Schutzummantelung umgebenen Abschnitt zu umgeben, und dadurch dass die zwei Aufnahmen an gegenüberliegenden Enden des Gehäuses vorgesehen sind.

2. Vorrichtung nach Anspruch 1, bei welcher die Verformungseinrichtung (6) einen Durchlass (10) zum Durchtritt des Lichtleiters (1) aufweist, der quer zu den Aufnahmen (4a, 4b) bewegbar ist.

3. Vorrichtung nach Anspruch 2, bei weicher die Verformungseinrichtung (6) relativ zu den Aufnahmen (4a, 4b) um eine Drehachse (13) verdrehbar ist, die zu einer durch die Öffnungen (5a, 5b) in den Aufnahmen (4a, 4b) gebildeten Zuführungsachse (11) versetzt ist.

4. Vorrichtung nach Anspruch 3, bei welcher die Verformungseinrichtung (6) als Hohlzylinder ausgebildet ist, der als Durchlass (10) eine exzentrische Bohrung aufweist.

5. Vorrichtung nach einem der vorhergehenden Ansprüche, bei der die Verformungseinrichtung (6) ein Bedienelement (12) aufweist, welches durch eine Öffnung in dem Gehäuse (14) geführt und von außerhalb des Gehäuses (14) betätigbar ist.

6. Vorrichtung nach einem der vorhergehenden Ansprüche, bei welcher die Verformungseinrichtung (6) ausgebildet ist, den Lichtleiter (1) in dem nicht ummantelten Abschnitt (9) des Lichtleitkabels (2) bis zu einem minimalen Biegeradius von 40 mm, bevorzugt von 25mm, insbesondere von 10 mm zu verbiegen.

7. Vorrichtung nach einem der vorhergehenden Ansprüche, bei dem der Lichtleiter (1) des Lichtleitkabels (2) durch die Aufnahmen (4a, 4b) und die dazwischen angeordnete Verformungseinrichtung (6) geführt ist,
wobei die Schutzummantelung zwei Abschnitte (7a, 7b) umfasst, die jeweils einen Abschnitt des Lichtleiters (1) außerhalb der Verformungseinrichtung (6) umgeben, wobei jeweils ein der Verformungseinrichtung (6) zugewandtes Ende jedes Abschnitts (7a, 7b) in einer der Aufnahmen (4a, 4b) fixiert ist.

8. Vorrichtung nach Anspruch 7, bei welcher die Schutzummantelung (7a, 7b) ausgebildet ist, beim Verbiegen einen minimalen Biegeradius von 150 mm nicht zu unterschreiten.

9. Laserbearbeitungsmaschine (17) mit einer Vorrichtung (20) nach einem der vorhergehenden Ansprüche.

10. Verfahren zur Herstellung einer Vorrichtung nach Anspruch 7 oder 8, umfassend die Schritte:
Durchführen des Lichtleiters (1) des Lichtleitkabels (2) durch den Durchlass (10) der Verformungseinrichtung (6),
Versehen des Lichtleiters (1) mit jeweils einem Abschnitt (7a, 7b) der Schutzummantelung an gegenüberliegenden Enden des Gehäuses (14), sowie Fixieren eines Endes jedes Abschnitts (7a, 7b) in einer der an den gegenüberliegenden Enden des Gehäuses (14) gebildeten Aufnahmen (4a, 4b).

## Claims

1. A device (20) for adjusting a beam profile of a laser beam, comprising:
a fibre optic cable (2) comprising a protective sleeve (7a, 7b) and a light guide (1) in which the laser beam is guided,
a deformation device (6) for deforming the light guide (1) in a section (9) of the fibre optic cable (2) not enclosed by the protective sleeve,
as well as two holders (4a, 4b) for fixing in each case one end of a section (7a, 7b) of the protective sleeve, wherein the holders (4a, 4b) each comprise an opening (5a, 5b) for feeding the light guide (1) to the deformation device (6),
**characterized in that** the fibre optic cable comprises at least one section which is not enclosed by the protective sleeve, **in that** the device comprises a housing which is designed to surround the fibre optic cable at least in the section which is not enclosed by the protective sleeve and **in that** the two holders are provided at opposite ends of the housing.

2. A device according to claim 1, in which the deformation device (6) has a passage (10) for the light guide (1) to pass through, which passage is movable transversely to the holders (4a, 4b).

3. A device according to claim 2, in which the deformation device (6) is rotatable relative to the holders (4a, 4b) about an axis of rotation (13) that is offset with respect to a feed axis (11) formed by the openings (5a, 5b) in the holders (4a, 4b).

4. A device according to claim 3, in which the deformation device (6) is in the form of a hollow cylinder, which has an eccentric bore as the passage (10).

5. A device according to any one of the preceding claims, in which the deformation device (6) comprises a control element (12) which is guided through an opening in the housing (14) and can be operated from outside the housing (14).

6. A device according to any one of the preceding claims, in which the deformation device (6) is designed to bend the light guide (1) in the section (9) of the fibre optic cable (2) with no sleeve up to a minimum bend radius of 40 mm, preferably 25 mm, in particular 10 mm.

7. A device according to any one of the preceding claims, in which the light guide (1) of the fibre optic cable (2) is guided through the holders (4a, 4b) and the deformation device (6) arranged therebetween,
wherein the protective sleeve comprises two sections (7a, 7b), which each enclose a respective section of the light guide (1) outside the deformation device (6), wherein one end of each section (7a, 7b) facing the deformation device (6) is fixed in a respective one of the holders (4a, 4b).

8. A device according to claim 7, in which the protective sleeve (7a, 7b) is designed on bending not to go below a minimum bend radius of 150 mm.

9. A laser processing machine (17) having a device (20) according to any one of the preceding claims.

10. A method for producing a device according to claim 7 or 8, comprising the following steps:
feeding the light guide (1) of the fibre optic cable (2) through the passage (10) of the deformation device (6),
providing the light guide (1) with one section (7a, 7b) of the protective sleeve at each of the opposite ends of the housing (14) and
fixing one end of each section (7a, 7b) in a respective one of the holders (4a, 4b) formed at the opposite ends of the housing (14).

## Revendications

1. Dispositif (20) de réglage d'un profil de faisceau d'un faisceau laser, comprenant :
un câble à guide de lumière (2) qui présente une gaine protectrice (7a, 7b) et un guide de lumière (1) dans lequel le faisceau laser est guidé,
un moyen de déformation (6) pour déformer le guide de lumière (1) dans une partie (9) du câble à guide de lumière (2) non entourée par la gaine protectrice,
ainsi que deux logements (4a, 4b) pour fixer chaque fois une extrémité d'une partie (7a, 7b) de la gaine protectrice, les logements (4a, 4b) présentant chacun une ouverture (5a, 5b) pour amener le guide de lumière (1) au moyen de déformation (6),
**caractérisé en ce que**
le câble à guide de lumière comprend au moins une partie non entourée par la gaine protectrice, par le fait que le dispositif comprend un boîtier qui est conçu pour entourer le guide de lumière au moins dans la partie non entourée par la gaine protectrice, et par le fait que les deux logements sont prévus à des extrémités opposées du boîtier.

2. Dispositif selon la revendication 1, dans lequel le moyen de déformation (6) présente un passage (10) pour la traversée du guide de lumière (1), qui est mobile transversalement aux logements (4a, 4b).

3. Dispositif selon la revendication 2, dans lequel le moyen de déformation (6) peut tourner par rapport aux logements (4a, 4b) autour d'un axe de rotation (13) qui est décalé par rapport à un axe d'amenée (11) formé par les ouvertures (5a, 5b) dans les logements (4a, 4b).

4. Dispositif selon la revendication 3, dans lequel le moyen de déformation (6) est réalisé sous la forme d'un cylindre creux qui présente un alésage excentrique en tant que passage (10).

5. Dispositif selon l'une des revendications précédentes, dans lequel le moyen de déformation (6) présente un élément de commande (12), lequel passe à travers une ouverture dans le boîtier (14) et peut être actionné depuis l'extérieur du boîtier (14).

6. Dispositif selon l'une des revendications précédentes, dans lequel le moyen de déformation (6) est conçu pour courber le guide de lumière (1) dans la partie (9) non gainée du câble à guide de lumière (2) jusqu'à un rayon de courbure minimal de 40 mm, de préférence de 25 mm, en particulier de 10 mm.

7. Dispositif selon l'une des revendications précédentes, dans lequel le guide de lumière (1) du câble à guide de lumière (2) est guidé par les logements (4a, 4b) et le moyen de déformation (6) disposé entre eux,
dans lequel la gaine protectrice comprend deux parties (7a, 7b) qui entourent chacune une partie du guide de lumière (1) à l'extérieur du moyen de déformation (6), chaque fois une extrémité de chaque partie (7a, 7b) tournée vers le moyen de déformation (6) étant fixée dans un des logements (4a, 4b).

8. Dispositif selon la revendication 7, dans lequel la gaine protectrice (7a, 7b) est conçue pour que, lors de la courbure, le rayon de courbure minimal ne soit pas inférieur à 150 mm.

9. Machine d'usinage au laser (17) comprenant un dispositif (20) selon l'une des revendications précédentes.

10. Procédé de fabrication d'un dispositif selon la revendication 7 ou 8, comprenant les étapes consistant à :
faire passer le guide de lumière (1) du câble à guide de lumière (2) à travers le passage (10) du moyen de déformation (6),
munir le guide de lumière (1) de chaque fois une partie (7a, 7b) de la gaine protectrice à des extrémités opposées du boîtier (14) et fixer une extrémité de chaque partie (7a, 7b) dans un des logements (4a, 4b) formés aux extrémités opposées du boîtier (14).
